# EUROPEAN PATENT APPLICATION

(11) **EP 4 506 944 A1**
(43) Date of publication of application: **12.02.2025**
(21) Application number: 24166905.0
(22) Date of filing: 27.03.2024
(51) Int. Cl.: G11C 11/56, G11C 16/10, G11C 16/26, G11C 16/32

(54) **MEMORY DEVICE**

(30) Priority: 10.08.2023 KR 20230105134; 20.10.2023 KR 20230141406
(71) Applicant: Samsung Electronics Co., Ltd., Suwon-si, Gyeonggi-do 16677 (KR)
(72) Inventor: PARK, Sehwan, 16677 Suwon-si (KR); KIM, Jinyoung, 16677 Suwon-si (KR); LEE, Jisang, 16677 Suwon-si (KR); JANG, Joonsuc, 16677 Suwon-si (KR)
(74) Representative: Marks & Clerk LLP

(57) **Abstract**

An example memory device includes a memory cell array, a page buffer including buffer units corresponding to a plurality of memory cells of a page, a control logic configured to control a first read operation such that first hard decision data based on a normal read level and first soft decision data based on an offset level with respect to a first page are stored in the page buffer. The control logic is configured to perform a control operation of outputting the first hard decision data to a memory controller after a second read operation with respect to a second page has started in response to a first command that requests read of the second page from the memory controller and outputting the first soft decision data to the memory controller while the second read operation is being performed in response to a second command from the memory controller.

## Description

### BACKGROUND

A non-volatile memory device includes multiple memory cells for non-volatilely storing data. A flash memory device may be used, as an example of a non-volatile memory device, in a mobile phone, a digital camera, a personal digital assistant (PDA), a portable computer device, a stationary computer device, and various other types of devices.

A memory device may write or read data according to various methods, and for example, the memory device may generate and output hard decision data and soft decision data in response to a read request from a memory controller. Hard decision data may be data read by using a normal read level having a certain voltage level, and soft decision data may be data read by using an offset level having a certain offset as compared to the normal read level. A memory controller may perform soft decision error correction that corrects errors in data by using hard decision data and soft decision data together.

However, since a memory device has to output hard decision data and soft decision data together to a memory controller, the time required to output data may increase and a delay may occur between read operations for multiple pages to secure time for data output.

### SUMMARY

The present disclosure relates to a memory device with improved read speed in a system that uses hard decision data and soft decision data, a memory system including the memory device, and an operating method of the memory device.

In general, according to some aspects, a memory device includes a memory cell array including a plurality of pages, wherein each of the plurality of pages includes a plurality of memory cells, a page buffer including buffer units corresponding to the plurality of memory cells of the page, wherein each of the buffer units includes a cache latch and first to N-th latches, and a control logic configured to control a first read operation such that first hard decision data based on a normal read level and first soft decision data based on an offset level with respect to a first page of the plurality of pages are stored in the page buffer, wherein the control logic is further configured to perform a control operation of outputting the first hard decision data to a memory controller after performance of a second read operation with respect to a second page has started in response to a first command that requests read of the second page among the plurality of pages from the memory controller and outputting the first soft decision data to the memory controller while the second read operation is being performed in response to a second command from the memory controller.

In general, according to some aspects, a memory device includes a page buffer, the page buffer includes buffer units corresponding to a plurality of memory cells, and an operating method of the memory device includes receiving a read command with respect to a first page of the memory device, storing first hard decision data based on a normal read level to a first latch of each of the buffer units, wherein the first hard decision data is read from the first page through a first read operation corresponding to the read command, storing first soft decision data based on an offset level to a second latch of each of the buffer units, wherein the first soft decision data is read from the first page, receiving, from a memory controller, a first command comprising a read request with respect to a second page of the memory device, outputting, to the memory controller, the first hard decision data after dumping the first hard decision data to a cache latch of each of the buffer units in response to the receiving of the first command, receiving a second command from the memory controller while a second read operation with respect to the second page is performed, dumping the first soft decision data to the cache latch during a dump-allowed section defined in the second read operation, in response to the second command, and outputting the first soft decision data dumped to the cache latch to the memory controller.

In general, according to some aspects, a memory system includes a memory device including a page buffer configured to store data read from a page, wherein the page buffer includes buffer units corresponding to a plurality of memory cells, and each of the buffer units includes a first latch, a second latch, a third latch, and a cache latch, and a memory controller configured to receive hard decision data based on a normal read level and soft decision data based on an offset level, wherein the hard decision data and the soft decision data are read from the page, wherein the memory controller is further configured to control the memory device to sequentially perform a first read operation with respect to a first page and a second read operation with respect to a second page, receive first hard decision data read by the first read operation from the memory device after the second read operation has started, in response to output of a first command to the memory device, and receive first soft decision data read by the first read operation from the memory device before the second read operation is completed, in response to output of a second command to the memory device while the second read operation is being performed.

As described herein, a "normal" read operation (otherwise known as a default read operation) may be a read operation for determining hard decision data using a normal read level. A normal read level (otherwise known as a default read level) may be a read level (e.g. a first read level) used for determining hard decision data. Hard decision data may be data indicating a state of a memory cell based on a normal read operation. Hard decision data may indicate a threshold voltage of a memory cell relative to the normal read level (e.g. whether the threshold voltage is greater than the normal read level). Soft decision data may be data indicating a state of a memory cell based first and second offset levels (e.g. a range between the first and second offset levels). The soft decision data may indicate whether the threshold voltage of a memory cell is within a threshold range.

At least some of the above and other features of the invention are set out in the claims.

### BRIEF DESCRIPTION OF THE DRAWINGS

Implementations of the present disclosure will be more clearly understood from the following detailed description taken in conjunction with the accompanying drawings.
FIG. 1 is a block diagram of an example of a memory system.
FIGS. 2A to 2C are diagrams showing examples of generating hard decision data and soft decision data.
FIG. 3 is a diagram showing a buffer unit of an example of a page buffer.
FIG. 4 is a flowchart showing an example of an operating method of a memory device.
FIG. 5 is a diagram showing timings of an example of a data read operation.
FIG. 6 is a block diagram showing an implementation example of a memory device.
FIG. 7 is a flowchart showing an example of an operating method of a memory system.
FIG. 8 is a flowchart showing a particular operation example of a memory system.
FIGS. 9 and 10 are diagrams showing an example of a memory system and an example of an operating method thereof.
FIGS. 11 to 15 are waveform diagrams showing operation examples of a memory system.
FIG. 16 is a perspective view showing an example of a memory block.
FIG. 17 is a block diagram showing an example of applying a memory device to a solid state drive (SSD) system.

### DETAILED DESCRIPTION

Hereinafter, the present disclosure will be described more fully with reference to the accompanying drawings, in which implementations of the present disclosure are shown.

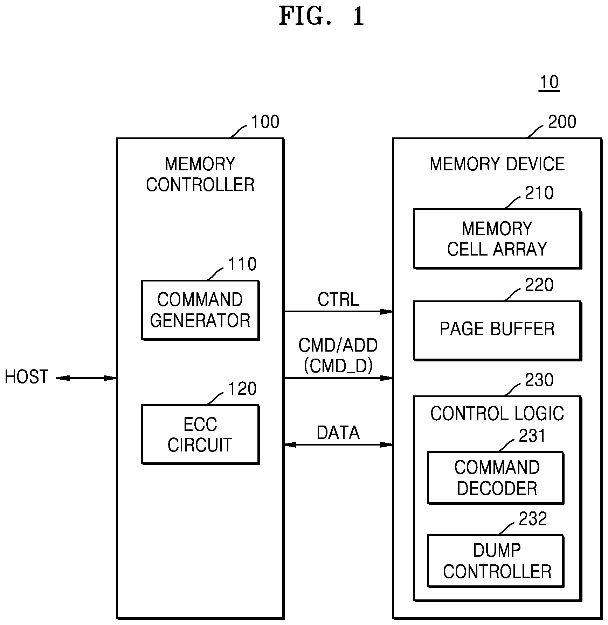

FIG. 1 is a block diagram of an example of a memory system.

Referring to FIG. 1, a memory system 10 may include a memory controller 100 and a memory device 200. The memory controller 100 may include a command generator 110 and an error correction code (ECC) circuit 120. In addition, the memory device 200 may include a memory cell array 210, a page buffer 220, and a control logic 230, and the control logic 230 may include a command decoder 231 and a dump controller 232. The memory controller 100 may provide, to the memory device 200, a command CMD, an address ADD, and a control signal CTRL, and the memory controller 100 may exchange data DATA with the memory device 200. In the example of FIG. 1, the command decoder 231 and the dump controller 232 are shown provided in the control logic 230, but the command decoder 231 and the dump controller 232 may also be implemented as separate components outside the control logic 230.

The memory system 10 may communicate with a host via various interfaces, and for example, the memory system 10 may communicate with the host through various interfaces such as a universal serial bus (USB) interface, a multimedia card (MMC) interface, an embedded MMC (eMMC) interface, a peripheral component interconnection (PCI) interface, a PCI-express (PCI-E) interface, an advanced technology attachment (ATA) interface, a serial-ATA, a parallel-ATA interface, a small computer small interface (SCSI), an enhance small disk interface (ESDI), an integrated drive electronics (IDE) interface, a firewire interface, a universal flash storage (UFS) interface, a non-volatile memory express (NVMe) interface, or the like.

The memory device 200 may include a non-volatile memory device such as flash memory or the like. In some implementations, the memory system 10 may be implemented as a memory built in or detachable from an electronic device. For example, the memory system 10 may be implemented in various forms such as a UFS memory device, an eMMC, a solid state drive (SSD), a UFS memory card, a compact flash (CF) memory, a secure digital (SD) memory, a micro-SD memory, a mini-SD memory, an extreme digital (xD) memory, a memory stick, or the like. Also, the memory system 10 may be referred to as a storage device as the memory system 10 non-volatilely stores data.

The memory controller 100 may control the memory device 200 to read data stored in the memory device 200 or write (or program) data to the memory device 200, in response to a write/read request from a host HOST. For example, the memory controller 100 may include a processor, and the processor may control all operations of the memory controller 100 and may also control a memory operation with respect to the memory device 200.

The memory cell array 210 may include a plurality of pages, and each page may include a plurality of memory cells corresponding to program and read units. For example, each page may include flash memory cells. Hereinafter, implementations are described based on a case in which the memory cells are NAND flash memory cells. However, the present disclosure is not limited thereto, and in some implementations, the plurality of memory cells may be resistive memory cells, such as resistive random-access memory (RAM) (ReRAM) memory cells, phase change RAM (PRAM) memory cells, or magnetic RAM (MRAM) memory cells.

In some implementations, the memory cell array 210 may include a three-dimensional memory cell array, the three-dimensional memory cell array may include a plurality of NAND strings, and each NAND string may include memory cells respectively connected to word lines stacked vertically on a substrate. However, the present disclosure is not limited thereto, and in some implementations, the memory cell array 210 may include a two-dimensional memory cell array, and the two-dimensional memory cell array may include a plurality of NAND strings arranged in row and column directions.

As a read command is provided to the memory device 200 from the memory controller 100, a read operation may be performed under control by the control logic 230. The page buffer 220 may store data in units of pages read from the memory device 200 and may include a plurality of buffer units arranged to correspond to a plurality of memory cells. Each of the plurality of buffer units may include one or more latches, and for example, each buffer unit may include a cache latch that exchanges data with an external controller, a sensing latch that senses data according to a voltage of a sensing node, and one or more data latches that store data.

As an operation example, when reading data of a page, hard decision data and soft decision data may be read for each memory cell. The hard decision data may correspond to data determined based on a normal (e.g. default) read level corresponding to a normal read operation, and the soft decision data may correspond to data determined based on an offset level having a certain offset as compared to the normal read level. For example, the offset level may include a first offset level having a negative (-) offset and a second offset level having a positive (+) offset as compared to the normal read level, and soft decision data may be generated based on a combination of values determined based on the first and second offset levels. The memory controller 100 may receive and use hard decision data and soft decision data to perform ECC decoding processing, and for example, the ECC circuit 120 may perform an error correction operation such as a low density parity check (LDPC).

The hard decision data and the soft decision data may be provided to the memory controller 100 according to various policies. For example, when an error has occurred in normal data (e.g., hard decision data) read from the memory device 200, the memory device 200 may generate soft decision data under control by the memory controller 100. Alternatively, regardless of an error detection result of normal data, the memory device 200 may generate and provide hard decision data and soft decision data to the memory controller 100 under the control by the memory controller 100.

In addition, in relation to a command for generating soft decision data, a read command that is separated from a read command that requests provision of normal data may be defined. The memory device 200 may generate hard decision data in response to receiving a read command and output the generated hard decision data to the memory controller 100. On the contrary, when the separate read command is provided to the memory device 200, the memory device 200 may generate hard decision data and soft decision data together and output the generated hard decision data and soft decision data to the memory controller 100.

As described above, hard decision data and soft decision data may be generated and output according to various policies. In the following implementations, regardless of an error detection result of normal data, it is described that the memory device 200 generates hard decision data and soft decision data together and provides the generated hard decision data and soft decision data to the memory controller 100, in response to a read command from the memory controller 100.

A particular operation example according to an implementation is described as follows.

A plurality of commands may be provided to the memory device 200 in relation to an operation of generating and outputting hard decision data and soft decision data with respect to one or more pages, and a series of operations according to execution of each command may be controlled based on a decoding result of the command decoder 231. For example, when the memory controller 100 provides a read command that requests read of a first page, the control logic 230 may control a first read operation related to the read of the first page, and first hard decision data and first soft decision data may be read from the first page through the first read operation. The first hard decision data and the first soft decision data of each memory cell may be stored in latches of a corresponding buffer unit, and for example, the first hard decision data may be stored in a sensing latch and the first soft decision data may be stored in a data latch.

In some implementations, the first hard decision data and the first soft decision data may be output to the memory controller 100 while one read operation is performed. For example, the memory controller 100 may output a command that requests read of a next second page, and the memory device 200 may output the first hard decision data and the first soft decision data together to the memory controller 100 during a second read operation of the second page. The dump controller 232 may control a dump operation between a plurality of latches included in each buffer unit so that hard decision data and soft decision data may be output together to the memory controller 100 during one read operation.

In some implementations, one or more commands related to output of hard decision data and soft decision data may be defined. For example, after the read of the first page is completed, a command (hereinafter referred to as a cache read command) that requests output of any one of hard decision data and soft decision data together with a read request for the next second page may be defined, and in addition, a command (hereinafter referred to as a dump command CMD_D) that requests output of the other piece of data may be defined. When it is assumed that hard decision data is output in response to a cache read command, the memory device 200 may perform the second read operation for the second page and also output the first hard decision data of the previously read first page to the memory controller 100, in response to the cache read command. Also, the memory device 200 may output the first soft decision data to the memory controller 100 while the second read operation is being performed in response to the dump command CMD_D.

As the first read operation is completed, the first soft decision data may be stored in the data latch, and the first soft decision data may be dumped to a cache latch in response to the dump command CMD_D. At this time, the sensing latch of the buffer unit may be electrically connected to other latches, and when a dump operation between latches is performed while a value of data of the second page is sensed, noise, such as a change in a voltage level of a sensing node of a sensing latch, may be caused. For example, a read operation may include a precharge section that precharges a voltage of a sensing node, a development section that develops the voltage of the sensing node, and a sensing section that determines a value of data according to the voltage of the sensing node, and the dump operation described above may be prohibited in some sections including the sensing section.

The dump command CMD_D may be provided to the memory device 200 at any point in time, and according to an implementation, some sections in which a read operation is performed may be defined as dump-allowed sections. When the memory device 200 receives the dump command CMD_D at a point in time that dump is not allowed, the memory device 200 may queue the dump command CMD_D until a dump-allowed section begins, and the first soft decision data may be dumped from a data latch to a cache latch during the dump-allowed section. When a dump-allowed section includes a portion of the precharge section described above, the memory device 200 may dump the first soft decision data to the cache latch within the precharge section. Thereafter, the memory device 200 may output the first soft decision data stored in the cache latch to the memory controller 100.

In some implementations, the memory device 200 may include a compressor, the compressor may perform a compression operation on the first soft decision data stored in the cache latch, and the compressed first soft decision data may be output to the memory controller 100. That is, the memory device 200 may be configured to compress the first soft decision data. The compression operation may result in the first soft decision data being smaller than the first hard decision data. The compression operation may be performed by various types of compression algorithms, such as lossy compression and non-lossy compression, and as compression is completed, soft decision data of any one page may be smaller in size than hard decision data.

The data dump and output operation described above may be applied the same to read operations for subsequent pages. For example, the memory device 200 may perform a third read operation with respect to a third page in response to a cache read command from the memory controller 100 and may output the second hard decision data of the second page to the memory controller 100 after the third read operation has started. Also, the memory device 200 may dump the second soft decision data of the second page to the cache latch and output the second soft decision data stored in the cache latch to the memory controller 100, in response to the dump command CMD_D from the memory controller 100.

According to the implementation described above, because both hard decision data and soft decision data may be output to the memory controller 100 during a read operation of any one page, the read speed and performance may be improved. For example, after any one read operation is completed, there is no need to delay performance of a next read operation to output at least one piece of hard decision data and soft decision data, and according to implementations, read operations with respect to a plurality of pages may be performed or a delay between the read operations may be reduced, and thus a decrease in read performance according to delay in a read operation may be prevented.

Although not illustrated in FIG. 1, the memory system 10 may control data dump and output operations according to implementations, based on hardware, software, or a combination thereof. For example, hardware circuits for determining a dump-allowed section and controlling a dump operation may be implemented in the memory device 200. Alternatively, the memory controller 100 and/or the memory device 200 may be provided with a component for storing instructions and a component for executing the instructions, so that the dump and output operations stated above may be controlled by software based on the execution of instructions.

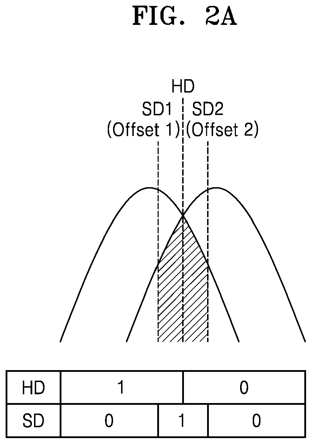

FIGS. 2A to 2C are diagrams showing examples of generating hard decision data and soft decision data.

Hard decision data and soft decision data may be generated together in the same read operation. Hard decision data and soft decision data may be determined through different read levels, and for example, the hard decision data and the soft decision may be generated in separate sensing sections by applying word line voltages having different levels to word lines.

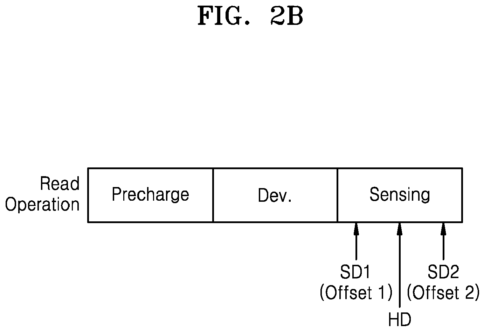

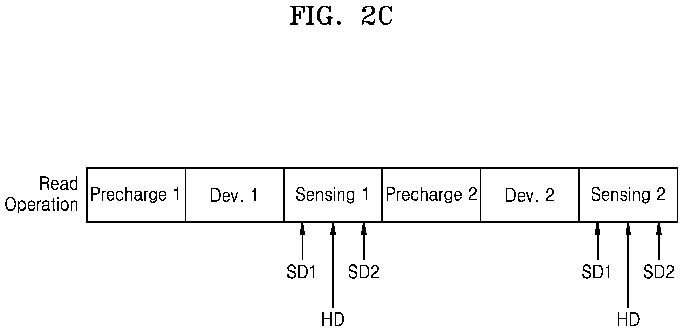

Alternatively, hard decision data corresponding to a normal read level and soft decision data corresponding to an offset level may be generated by using different sensing timings in any one sensing section. For example, when a sensing timing is relatively fast, a data value may be determined based on a relatively low threshold voltage level, and conversely, when a sensing timing is relatively late, a data value may be determined based on a relatively high threshold voltage level. FIGS. 2B and 2C show examples in which hard decision data and soft decision data are generated by adjusting sensing timings in the same sensing section, as described above.

Referring to FIGS. 1 and 2A, the memory device 200 may output data determined based on a normal read level as hard decision data HQ and may output data determined based on an offset level as soft decision data SD. The offset level may include a first offset level Offset 1 having a level that is a first offset less than the normal read level of the normal read operation, and a second offset level Offset 2 having a level that is a second offset larger than the normal read level. That is, the first offset level Offset 1 may be equal to the normal read level minus the first offset and the second offset level Offset 2 may be equal to the sum of the normal read level and the second offset. A memory device may generate the soft decision data SD based on values determined by using the first offset level Offset 1 and the second offset level Offset 2. Also, the first offset may be the same as or different from the second offset.

The normal read level may be a level (e.g. a first level) used for the determination of a value of the hard decision data HD. For example, the hard decision data HQ of a memory cell having a lower threshold voltage as compared with the normal read level may have a value of "1", and the hard decision data HQ of a memory cell having a higher threshold voltage as compared with the normal read level may have a value of "0". Also, the soft decision data SD of a memory cell having a threshold voltage lower than the first offset level Offset 1 or higher than the second offset level Offset 2 may have a value of "0". Conversely, the soft decision data SD of a memory cell having a threshold voltage between the first offset level Offset 1 and the second offset level Offset 2 may have a value of "1". The soft decision data SD may include information indicating whether the memory cell has a strong error or a weak error. Accordingly, hard decision data may indicate a particular value initially read from the memory cell (e.g. based on a hard decision of whether the threshold voltage is greater than the normal read level (the first level)). Soft decision data may indicate whether the threshold voltage of the memory cell is within a particular range of the normal read level. Various parameters, such as coefficients used in error calculation, may be calculated based on the hard decision data HQ and the soft decision data SD.

Referring to FIG. 2B, a read operation may include a plurality of sections, and for example, may include a precharge section, a development section, and a sensing section. In the precharge section, a sensing node may be precharged with a voltage of a certain level. Also, in the development section, a voltage level of the sensing node may be changed according to data stored in a memory cell. For example, when the memory cell is programmed with a relatively low threshold voltage corresponding to an on cell, the voltage level of the sensing node may drop rapidly, and conversely, when the memory cell is programmed with a relatively high threshold voltage corresponding to an off cell, the voltage level of the sensing node may gradually fall.

In the sensing section, a sensing operation may be performed at least twice at different sensing timings to determine the hard decision data HQ and the soft decision data SD. According to the above timings, a data value based on the first offset level Offset 1, the normal read level, and the second offset level Offset 2 in the above implementation may be determined, and the hard decision data HQ and the second offset level Offset 2 may be generated through the sensing operations.

Referring to FIG. 2C, each memory cell may store data of 2 bits or more, and the memory cells may have three or more threshold voltage distributions depending on program states thereof. In this case, to determine a data value of each memory cell, a data sensing operation may be required at positions of at least two threshold voltage distributions, and in FIG. 2C, a case in which one read operation includes two read sections is described as an example. A first read section may include a first precharge section, a first development section, and a first sensing section, and a second read section may include a second precharge section, a second development section, and a second sensing section. Also, the hard decision data HQ and the soft decision data SD with respect to each memory cell may be generated by using the values determined in the first read section and the second read section.

A sensing operation similar to that of the implementation of FIG. 2B may be performed in each of the first read section and the second read section. For example, sensing operations based on the first offset level Offset 1, the normal read level, and the second offset level Offset 2 may be performed in each of the first sensing section and the second sensing section.

The dump-allowed section described above may be defined to include various sections. For example, the dump-allowed section may include a portion of the precharge section. Alternatively, the dump-allowed section may be defined as including at least a portion of the precharge section but not including the sensing section. In addition, although not shown in the above implementations, the read operation may further include other additional sections such as a recovery section that performs recovery with respect to various types of nodes or lines after the sensing section, and the dump-allowed section may be defined to include various sections within a range that does not cause noise to a data sensing operation.

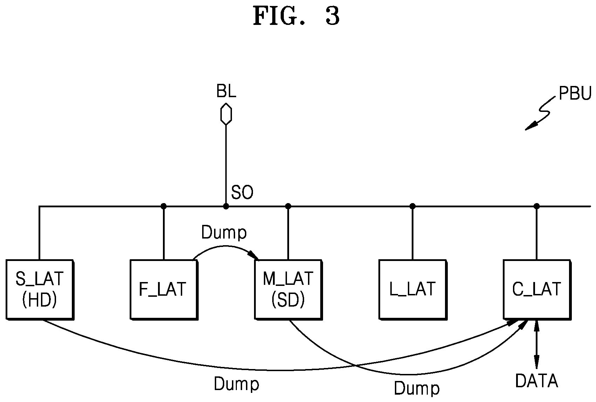

FIG. 3 is a diagram showing a buffer unit of an example of a page buffer. FIG. 3 shows a schematic configuration of latches included in a buffer unit PBU connected to any one bit line BL. For example, each memory cell may store data of at least two bits, and it is assumed that the buffer unit PBU includes five latches.

Referring to FIG. 3, the buffer unit PBU may be connected to the bit line BL through a sensing node SO and include a fifth latch (e.g., a cache latch C_LAT), and the cache latch C_LAT may store data received from the outside or output data to the outside. Also, data DATA may be dumped between the cache latch C_LAT and other latches.

The buffer unit PBU may further include a first latch (e.g., a sensing latch S_LAT), a second latch (e.g., a force latch F _LAT), a third latch (e.g., a first data latch M_LAT), and a fourth latch (e.g., a second data latch L_LAT). For example, the sensing latch S_LAT may be a latch that senses the hard decision data HQ, and the force latch F _LAT may be used to sense the soft decision data SD. In addition, the force latch F_LAT may be further used to store forcing information for finely changing a threshold voltage distribution during a programming process of data.

As an operation example, a value according to a certain calculation (e.g., XOR calculation) result with respect to values determined through two offset levels may be stored in the buffer unit PBU as the soft decision data SD. For example, a value determined based on the first offset level may be dumped and stored in the first data latch M_LAT. Also, in a process of dumping a value determined based on the second offset level to the first data latch M_LAT, a buffer unit may be implemented so that the value according to the XOR calculation result may be stored.

The hard decision data HQ and the soft decision data SD may be output to a memory controller after being dumped to the cache latch C_LAT. At this time, the sensing latch S_LAT and the force latch F_LAT may be electrically connected to other latches, and a sensing operation of determining a data value and an operation of dumping the hard decision data HQ and/or the sensing latch S_LAT to the cache latch C_LAT may be performed in parallel. Accordingly, when performance of a next read operation is delayed to secure time for outputting the hard decision data HQ and/or the soft decision data SD after any one read operation is completed, a problem in which the read speed is reduced may occur.

In some implementations, a dump-allowed section that allows a dump may be defined in the buffer unit PBU so that a dump command that requests output of soft decision data during a read operation is defined, and the output of the soft decision data becomes possible, and thus the hard decision data HQ and the soft decision data SD may be output together to a memory controller in one read operation. Accordingly, as a second read operation is continuously performed without an additional delay occurring after the first read operation is completed, or a delay between the first read operation and the second operation is reduced, the read speed may be improved.

In the implementation of FIG. 3, the soft decision data SD generated based of the first/second offset levels is described as being stored in the first data latch M_LAT, but the implementations may be implemented by various methods. For example, the buffer unit PBU may be implemented so that the soft decision data SD, which is finally generated, is stored in the force latch F_LAT.

In addition, in some implementations, a case in which the soft decision data SD is output to a memory controller based on a dump-allowed section after the hard decision data HQ is firstly output to the memory controller is described, but the present disclosure is not limited thereto. For example, a memory system may also be implemented so that the hard decision data HQ is output to the memory controller based on the dump-allowed section after the soft decision data SD is firstly output to the memory controller.

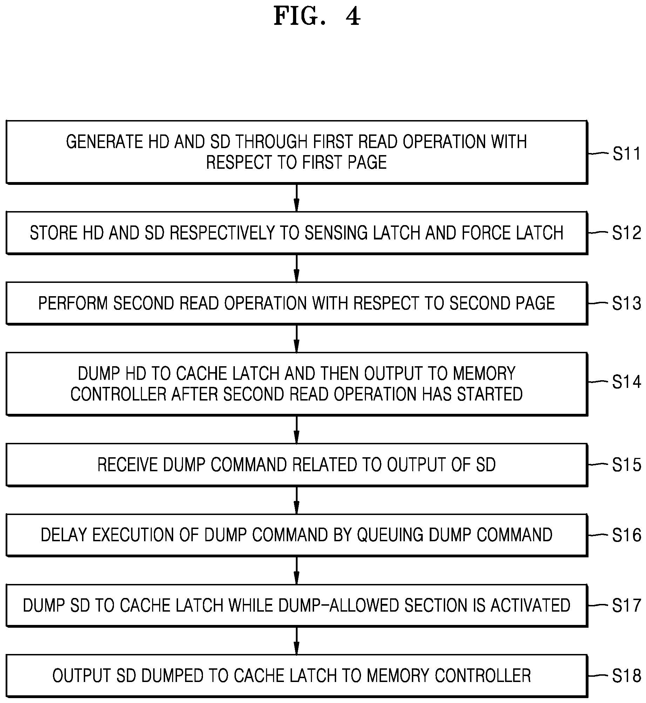

FIG. 4 is a flowchart showing an example of an operating method of a memory device. In FIG. 4, a case in which the hard decision data HD and the soft decision data SD generated in a first read operation with respect to a first page are output to a memory controller during a second read operation with respect to a second page is described.

A memory device may generate the hard decision data HD and the soft decision data SD of the first page by performing the first read operation under control by the memory controller (S11). The generated hard decision data HD may be stored in a first latch (e.g., a sensing latch) within a buffer unit, and the soft decision data SD may be stored in a second latch within the buffer unit. The second latch may be any latch within the buffer unit, and for example, may be a force latch or a first data latch, and in FIG. 4, it is assumed that the soft decision data SD is stored in the force latch.

Thereafter, the memory device may perform the second read operation with respect to the second page under control by the memory controller (S13). Also, the memory device may dump the hard decision data HD to a third latch (e.g., a cache latch) after the second read operation has started and may output the hard decision data HD stored in the cache latch to the memory controller (S 14). In addition, the memory device may receive a dump command related to output of the soft decision data SD from the memory controller (S15), and for example, the dump command may be received from the memory controller at any point in time.

The memory device may internally determine a section in which a dump operation is possible and may delay execution of the dump command by queuing the dump command (S16). The memory device may dump the soft decision data SD to the cache latch by executing the dump command as a dump-allowed section is activated (S17), and may output the soft decision data SD dumped to the cache latch to the memory controller (S18).

Because the sensing latch and the force latch are used for sensing the hard decision data HD and the soft decision data SD in the second read operation with respect to the second page, when the read operation with respect to the second page starts, the hard decision data HD and the soft decision data SD need to be dumped directly to their respective latches. As an operation example, the soft decision data SD may be dumped to another latch (e.g., a first or second data latch) in parallel with or sequentially with an operation of dumping the hard decision data HD to the third latch. Alternatively, when a sensing operation related to the soft decision data SD is performed through the force latch and the first data latch, and the soft decision data SD, which is finally determined, is stored in the first data latch, the soft decision data SD may be dumped to the second data latch.

As the dump command is executed, the soft decision data SD stored in the first or second data latch may be dumped to the cache latch. In the following implementations, an operation of dumping the soft decision data SD to the cache latch in response to the dump command may be defined as a concept including operations of dumping the soft decision data SD stored in any latch (e.g., the force latch or the data latch) within the buffer unit to the cache latch.

According to the above implementations, the hard decision data HD and the soft decision data SD generated in the first read operation may be output to the memory controller while the second read operation is being performed. That is, because the hard decision data HD and the soft decision data SD may be output together to the memory controller during the second read operation, the second read operation may be continuously performed after the first read operation is completed, or a delay between the first read operation and the second read operation may be reduced.

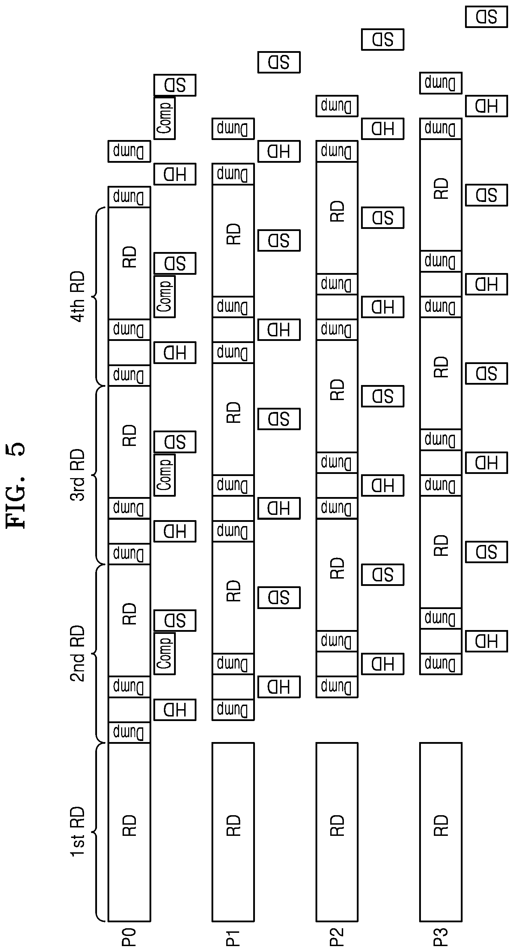

FIG. 5 is a diagram showing timings of an example of a data read operation. In FIG. 5, a case in which first to fourth planes P0 to P3 are provided in a memory device as a plurality of planes, and read operations with respect to the first to fourth planes P0 to P3 are performed in parallel is described. For example, the hard decision data HD and the soft decision data SD of the first to fourth planes P0 to P3 may be sequentially output to a memory controller at different time sections. An operation example of the present disclosure is described as follows with reference to a read operation with respect to pages of the first plane P0.

Referring to FIG. 5, the hard decision data HD and the soft decision data SD generated through a first read operation with respect to a first page may be stored in a page buffer, and the memory device may perform a second read operation sequentially to the first read operation in response to a first command that requests read of data of a second page. After the second read operation has started, the memory device may dump the hard decision data HD, which is previously read and stored in a sensing latch, to a cache latch and output the same to the memory controller.

Thereafter, the memory device may receive a second command that requests output of soft decision data from the memory controller and may delay execution of the second command until a dump-allowed section by queuing the second command. The memory device may confirm entry of the dump-allowed section and execute the second command to dump the soft decision data SD to the cache latch during the dump-allowed section. Thereafter, the memory device may perform a compression operation on the soft decision data SD stored in the cache latch and output the compressed soft decision data SD to the memory controller. The above operation may be performed the same in subsequent reading operations.

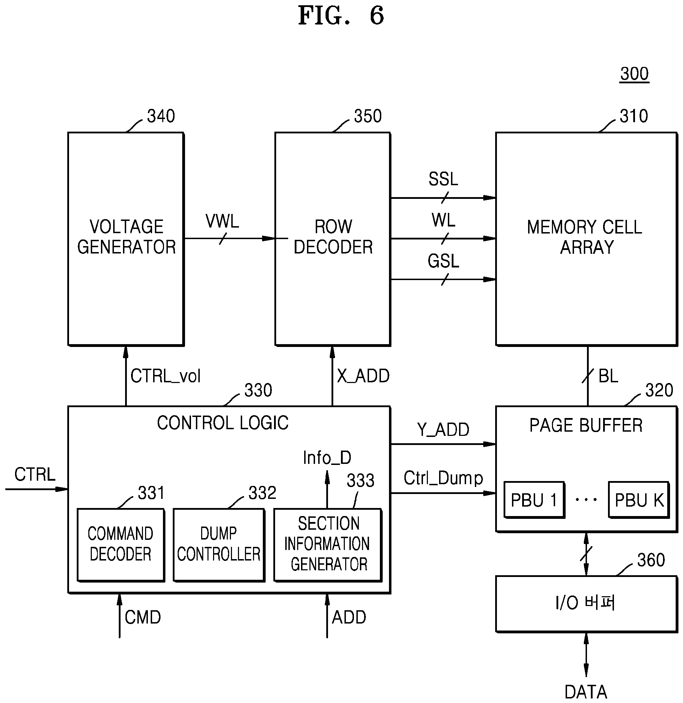

FIG. 6 is a block diagram showing an implementation example of a memory device. Referring to FIG. 6, a memory device 300 may include a memory cell array 310, a page buffer 320, a control logic 330, a voltage generator 340, a row decoder 350, and an input/output buffer 360. Also, the control logic 330 may include a command decoder 331, a dump controller 332, and a section information generator 333.

The memory cell array 310 may include a plurality of pages, and the memory cell array 310 may be connected to word lines WL, a string selection line SSL, a ground selection line GSL, and bit lines BL. In particular, the memory cell array 310 may be connected to the row decoder 350 through the word lines WL, the string selection line SSL, and the ground selection line GSL and may be connected to the page buffer 320 through the bit lines BL.

The page buffer 320 may be connected to the bit line BL to temporarily store read data or temporarily store write data. The page buffer 320 may include a plurality of buffer units (for example, first to k-th buffer units PBU 1 to PBU K) in correspondence to a plurality of memory cells of a page, and each buffer unit may be connected to a corresponding bit line BL through a sensing node and may include a plurality of latches.

The control logic 330 may program data to the memory cell array 310 or read data from the memory cell array 310 based on the command CMD, the address ADD, and the control signal CTRL from a memory controller. Various internal control signals output from the control logic 330 may be provided to the page buffer 320, the voltage generator 340, and the row decoder 350. In particular, the control logic 330 may provide a voltage control signal CTRL_vol to the voltage generator 340. The voltage generator 340 may provide, to the row decoder 350, word line voltages VWL of various levels in relation to program/read/erase operations. Also, the control logic 330 may provide a row address X_ADD to the row decoder 350, provide a column address Y_ADD to the page buffer 320, and also output a dump control signal Ctrl_Dump for controlling a dump operation in relation to read and output of data.

In some implementations, the command decoder 331 may decode a command from a memory controller and control a read operation and an output operation of data based on a decoding result. The dump controller 332 may control a dump operation with respect to latches in the page buffer 320 based on the decoding result and according to implementations, may control a dump operation so that hard decision data and soft decision data may be output together to the memory controller during any one read operation. In addition, the section information generator 333 may generate section information Info_D indicating a dump-allowed section in which data may be dumped to a cache latch while a read operation is performed. The control logic 330 may control a dump operation and an output operation of data based on the section information Info_D of the section information generator 333.

According to the implementation shown in FIG. 6, the memory device 300 may control a series of operations for outputting hard decision data and soft decision data based on the command CMD of the memory controller. For example, in a state in which the hard decision data and the soft decision data are stored in the page buffer 320, the memory device 300 may control a dump operation of dumping the hard decision data and the soft decision data to the cache latch based on the decoding result of the received command CMD and may also output the hard decision data and the soft decision data stored in the cache latch to the memory controller.

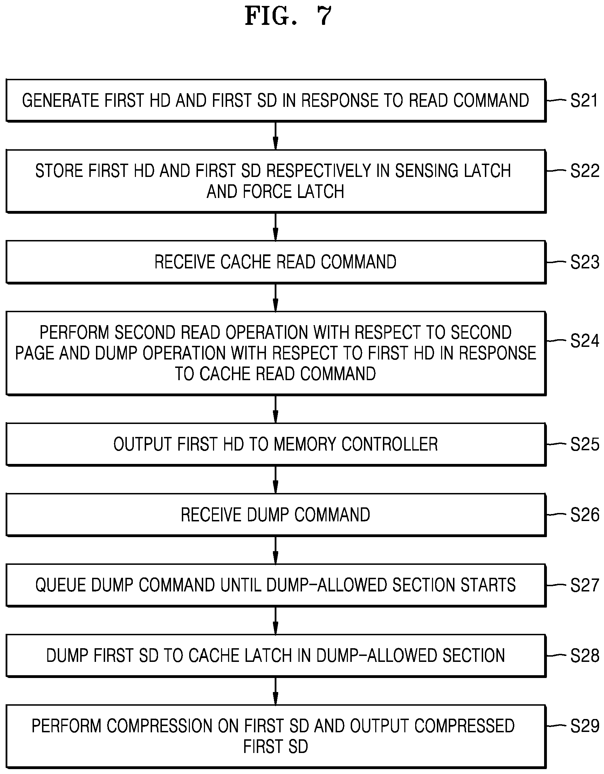

FIG. 7 is a flowchart showing an example of an operating method of a memory system.

Referring to FIG. 7, a memory controller may provide a read command with respect to a first page to a memory device, and the memory device may generate first hard decision data and first soft decision data through a first read operation in response to the read command (S21). Also, the first hard decision data and the first soft decision data may be stored in a latch within a page buffer, and for example, the first hard decision data may be stored in a sensing latch and the first soft decision data may be stored in a force latch (S22).

Thereafter, the memory device may receive a cache read command from the memory controller (S23), perform a second read operation with respect to a second page with respect to the cache read command, and also dump the first hard decision data stored in the sensing latch to the cache latch (S24). In addition, the memory device may output the first hard decision data stored in the cache latch to the memory controller (S25).

The memory device may receive a dump command from the memory controller at any point in time while the second read operation is being performed (S26). The memory device may check a logic state of internally generated section information and queue the dump command until the dump-allowed section starts (S27). The memory device may execute the dump command in the dump-allowed section according to the logic state of the section information and may dump the first soft decision data to the cache latch as the dump command is executed (S28). In addition, the memory device may output the first soft decision data stored in the cache latch to the memory controller (S29), and for example, the memory device may perform compression on the first soft decision data and output the compressed first soft decision data.

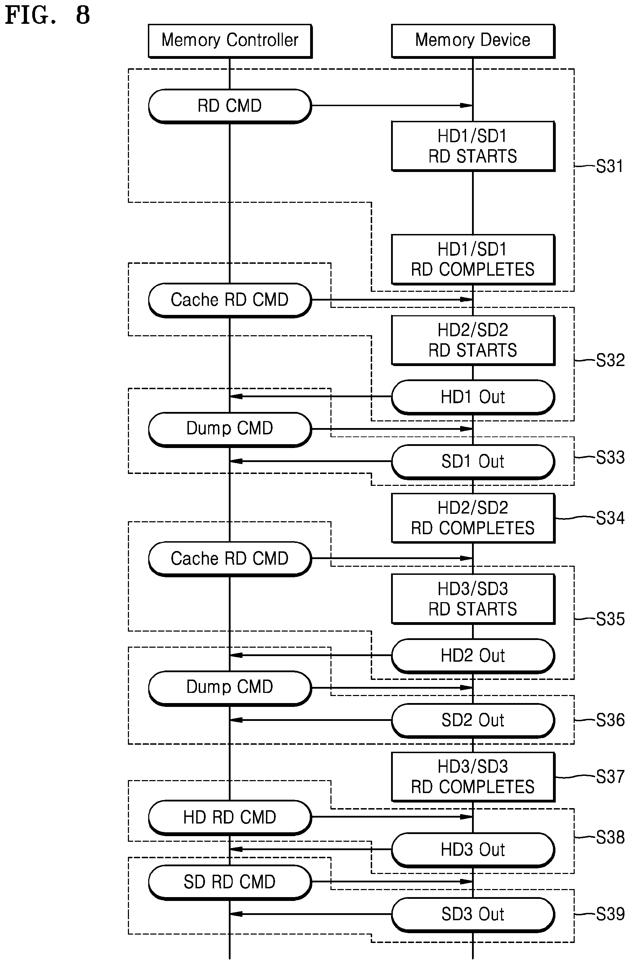

FIG. 8 is a flowchart showing a particular operation example of a memory system.

Referring to FIG. 8, a memory controller may sequentially output a series of commands in relation to a read operation with respect to a plurality of pages and output of read hard decision data and soft decision data. In addition, a memory device may perform a series of one or more internal operations in response to any one command from the memory controller. In some implementations, FIG. 8 illustrates first to fifth commands in relation to read and output of hard decision data and soft decision data.

In operation S31, the memory controller may output a first command corresponding to a read command, and the memory device may read first hard decision data HD1 and first soft decision data SD1 from a first page in response to the first command. A first read operation with respect to the first page may be completed, the first hard decision data HD1 may be stored in a first latch (e.g., a sensing latch) within a page buffer of the memory device, and the first soft decision data SD1 may be stored in a second latch (e.g., a force latch) within the page buffer.

Thereafter, in operation S32, the memory controller may output a second command corresponding to a cache read command, and the memory device may start a second read operation for reading second hard decision data HD2 and second soft decision data SD2 from a second page in response to the second command. In addition, the memory device may dump the first hard decision data HD1 stored in the first latch to a cache latch in response to a second command and output the first hard decision data HD1 stored in the cache latch to the memory controller. Also, the memory device may further perform an operation of dumping the first soft decision data SD1 stored in the second latch to a third latch (e.g., a data latch) in response to the second command.

Thereafter, in operation S33, the memory controller may output a third command corresponding to a dump command, and the memory device may dump the first soft decision data SD1 stored in the third latch to the cache latch during a dump-allowed section and output the first soft decision data SD1 stored in the cache latch to the memory controller. Also, in operation S34, as the second read operation, which has started previously, is completed, the second hard decision data HD2 may be stored in the first latch within the page buffer and the second soft decision data SD2 may be stored in the second latch within the page buffer.

Thereafter, in operation S35, the memory controller may output the second command corresponding to the cache read command, and the memory device may start a third read operation for reading third hard decision data HD3 and third soft decision data SD3 from a third page in response to the second command. In addition, the memory device may dump the second hard decision data HD2 stored in the first latch to the cache latch in response to the second command and output the second hard decision data HD2 stored in the cache latch to the memory controller.

Thereafter, in operation S36, the memory controller may output a third command corresponding to a dump command, and the memory device may dump the second soft decision data SD2 stored in the third latch to the cache latch in response to the third command during a dump-allowed section and output the second soft decision data SD2 stored in the cache latch to the memory controller. Also, in operation S37, as the third read operation, which has started previously, is completed, the third hard decision data HD3 may be stored in the first latch within the page buffer and the third soft decision data SD3 may be stored in the second latch within the page buffer.

According to the above operations, first to third hard decision data and first to third soft decision data are all read, and the third hard decision data and the third soft decision data correspond to a state that has not been output to the memory controller. In operation S38, the memory controller may provide a fourth command corresponding to a hard decision data read command to the memory device, and the memory device may dump the third hard decision data HD3 to the cache latch and output the third hard decision data HD3 stored in the cache latch to the memory controller without performing an additional read operation. Also, in operation S39, the memory controller may provide a fifth command corresponding to a soft decision data read command to the memory device, and the memory device may dump the third soft decision data SD3 to the cache latch and output the third soft decision data SD3 stored in the cache latch to the memory controller. In some implementations, because the memory device is not performing a read operation, the third soft decision data SD3 may be dumped to the cache latch regardless of a dump-allowed section to be output to the memory controller.

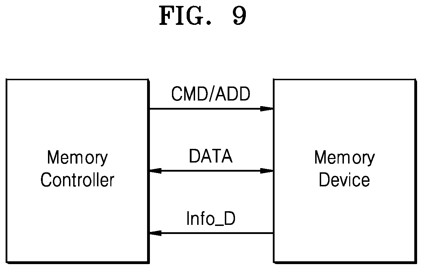

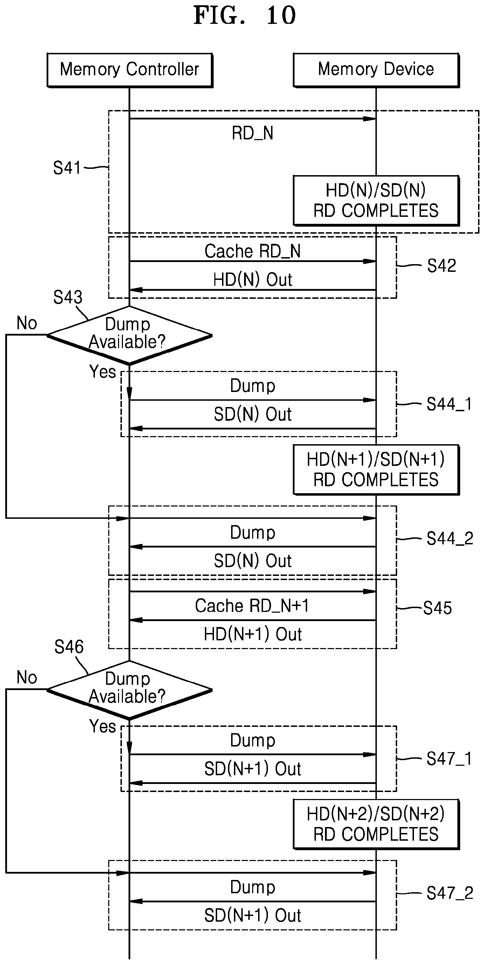

FIGS. 9 and 10 are diagrams showing an example of a memory system and an example of an operating method thereof.

Referring to FIG. 9, a memory system may include a memory controller and a memory device, the memory controller may output the address ADD and the command CMD to the memory device, and the hard decision data HQ and the soft decision data SD read from the memory device may be provided to the memory controller. Also, according to the implementations described above, a dump-allowed section may be defined while a read operation is performed, and the memory device may generate the section information Info_D indicating the dump-allowed section and provide the generated section information Info_D to the memory controller. For example, when the section information Info_D has a first logic state, the memory device may dump hard decision data or soft decision data to a cache latch. Conversely, while the section information Info_D has a second logic state, an operation of dumping the hard decision data or the soft decision data to the cache latch may be prohibited.

The memory controller may receive hard decision data from the memory device by outputting a cache read command according to the implementations described above. Also, the memory controller may check the logic state of the section information Info_D and may output a dump command to the memory device when the section information Info_D has the first logic state. The memory device may dump the soft decision data to the cache latch while the section information Info_D has the first logic state. An operation of dumping hard decision data or soft decision data to the cache latch may correspond to an operation of preparing output of data.

Referring to FIG. 10, in operation S41, the memory controller may output a read command RD_N, and the memory device may perform a read operation with respect to an N-th page in response to the read command RD_N. As the read operation with respect to the N-th page is completed, N-th hard decision data HD(N) may be stored in a first latch (e.g., a sensing latch) within a page buffer, and N-th soft decision data SD(N) may be stored in a second latch (e.g., a force latch) within the page buffer.

Thereafter, in operation S42, the memory controller may output a cache read command Cache RD_N, and the memory device may start a read operation with respect to an (N+1)-th page in response to the cache read command Cache RD_N. In addition, the memory device may dump the N-th hard decision data HD(N) stored in the first latch to a cache latch in response to the cache read command Cache RD_N and may output the N-th hard decision data HD(N) stored in the cache latch to the memory controller. In defining a term of the cache read command Cache RD_N, the symbol "N" is used in relation to output of data of the N-th page, but the cache read command Cache RD_N may also be defined to be expressed by a symbol "Cache Rd_N+1" in relation to the fact of including a read request with respect to the next (N+1)-th page.

In operation S43, the memory controller may check a logic state of the section information Info_D provided from the memory device and may determine whether a state of the memory device corresponds to a dump-allowed section. When it is determined that the state of the memory device corresponds to the dump-allowed section, according to operation S44_1, the memory controller may output a dump command Dump, and the memory device may dump the N-th soft decision data SD(N) stored in the second latch or another latch (e.g., a data latch) to the cache latch during the dump-allowed section in response to the dump command Dump. Also, the memory device may output the N-th soft decision data SD(N) stored in the cache latch to the memory controller.

Conversely, when a dump-allowed section does not exist until a read operation with respect to the (N+1)-th page is completed, according to operation S44_2, the memory controller may output the dump command Dump after the read operation with respect to the (N+1)-th page is completed, and may receive the N-th soft decision data SD(N) from the memory device.

Thereafter, in operation S45, the memory controller may output a cache read command Cache RD_N+1, and the memory device may start a read operation with respect to an (N+2)-th page in response to the cache read command Cache RD_N+1 and may dump (N+1)-th hard decision data HD(N+1) stored in the first latch to the cache latch and output the (N+1)-th hard decision data HD(N+1) to the memory controller. In addition, as in the operation described above, in operation S46, the memory controller may check the logic state of the section information Info_D and output the dump command Dump to the memory device while a read operation with respect to an (N+2)-th page is performed according to operation 47_1 based on a check result. When a dump-allowed section does not exist until the read operation with respect to the (N+2)-th page is completed, according to operation S47_2, the memory controller may output the dump command Dump after the read operation with respect to the (N+2)-th page is completed.

According to the implementations described above, because the memory controller may check the logic state of the section information Info_D to output a dump command, the memory device may perform a dump operation of data by executing the dump command without queuing the dump command for a long time. Also, based on the logic state of the dump-allowed section, when both hard decision data and soft decision data may not be output during one read operation, a control operation may be performed to output any one data (e.g., the soft decision data) after the read operation is completed, and thus the stability of data input/output may be secured.

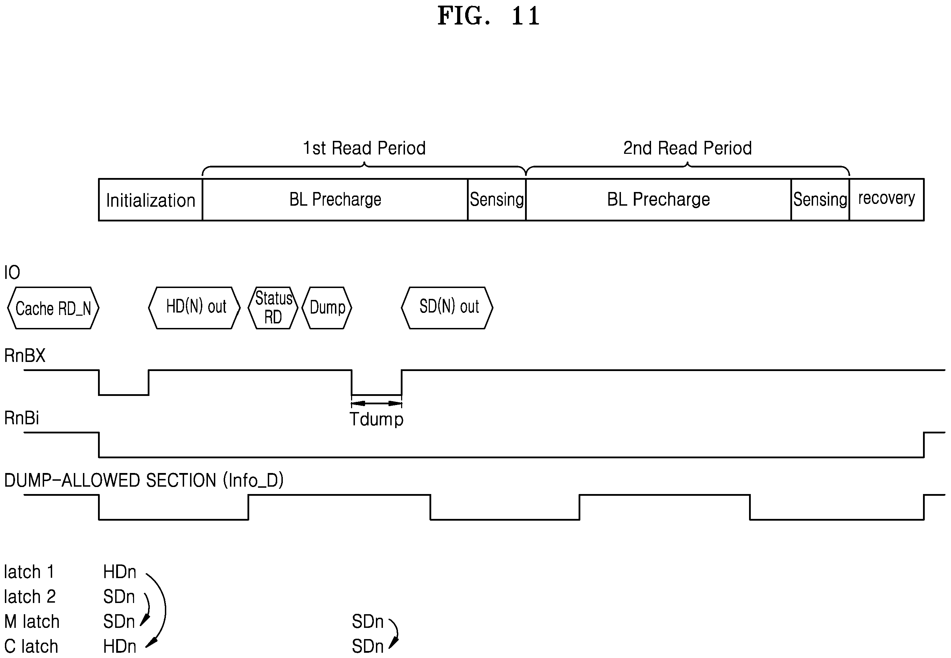

Hereinafter, operating examples of a memory system according to various implementations are described. FIGS. 11 to 15 are waveform diagrams showing operation examples of a memory system. In FIGS. 11 to 15, as each of memory cells of a memory device stores data of two bits or more, a read operation includes a plurality of read sections for determining at least two threshold voltage distributions, and a case in which the read operation includes a first read section and a second section is described as an example. Also, the read operation may further include at least one section in addition to the read sections described above, and for example, the read operation may include, before the read section starts, an initialization section that performs initialization of various lines and nodes of a page buffer, and a recovery section with respect to various lines and nodes after the read section is completed. Also, for convenience of illustration, although not illustrated in FIGS. 11 to 15, a read section may further include a development section before a sensing section, and a dump-allowed section of the implementations may include or not include a portion of the development section.

The dump-allowed section according to some implementations may define a section in which dump is allowed in the read section. In sections (e.g., the initialization section and the recovery section) other than the read section, a dump operation may be performed regardless of the section information Info_D. Also, in the implementations of FIGS. 11 to 15, it is assumed that soft decision data is stored in a force latch as a read operation is completed and the soft decision data is dumped from the force latch to the first data latch M_LAT in response to a cache read command.

Referring to FIG. 11, a memory device may store N-th hard decision data and N-th soft decision data, which were previously read from an N-th page, in a page buffer, and for example, the N-th hard decision data may be stored in a first latch (e.g., a sensing latch) within a page buffer and the N-th soft decision data may be stored in a second latch (e.g., a force latch) within the page buffer.

The memory device may generate an external ready/busy signal RnBx and an internal ready/busy signal RnBi and output the external ready/busy signal RnBx to a memory controller. In addition, the memory device may perform various internal operations in relation to data write and read operations based on a logic state of the internal ready/busy signal RnBi. The internal ready/busy signal RnBi may maintain a logic low state during a read operation. Also, in some implementations, the memory device may further generate the section information Info_D indicating a dump-allowed section, and in the implementation shown in FIG. 11, a case in which the memory device outputs the section information Info_D to the memory controller in response to a state read command Status RD from the memory controller is described.

The memory device may input/output a command, information, data, or the like to/from the memory controller during a section in which the external ready/busy signal RnBx is logic high, and for example, the memory device may receive the cache read command Cache RD_N from the memory controller. The external ready/busy signal RnBx may be changed to a logic low state during a certain section in response to the cache read command Cache RD_N, and the memory device may, during a logic low section of the external ready/busy signal RnBx, dump the N-th hard decision data HD(N) stored in the first latch to the cache latch and dump the N-th soft decision data SD(N) stored in the second latch to the first data latch M_LAT and may also output the N-th hard decision data HD(N) dumped to the cache latch to the memory controller. In addition, the memory device may perform a read operation with respect to an (N+1)-th page in parallel with the output of the N-th hard decision data HD(N).

In some implementations, the memory controller may output the state read command Status RD that requests transmission of the section information Info_D to the memory device, and the memory device may output the section information Info_D to the memory controller. FIG. 11 illustrates a case in which the state read command Status RD is provided to the memory device after the output of the N-th hard decision data HD(N), but the present disclosure is not limited thereto, and the state read command Status RD may be provided to the memory device at various random points in time.

A dump-allowed section may include one or more sections in each read operation, and FIG. 11 illustrates a case in which the dump-allowed section includes a portion of a precharge section of each of a first read operation and a second read operation. The memory controller may output the dump command Dump in the dump-allowed section, and the memory device may determine whether a dump operation may be completed while the section information Info_D has a first logic state by considering time Tdump required for the dump operation. The dump operation may be performed if the remaining time in the dump-allowed section after receipt of the dump command is greater than or equal to the time Tdump required for the dump operation. When the dump operation is performed, the external ready/busy signal RnBx may be changed to a logic low state during a certain section in response to a dump command, and the memory device may, during the logic low section of the external ready/busy signal RnBx, dump the N-th soft decision data SD(N) to the cache latch and output the N-th soft decision data SD(N) dumped to the cache latch to the memory controller. According to the above operations, the N-th hard decision data HD(N) and the N-th soft decision data SD(N), which were read from the N-th page, may all be provided to the memory controller during a read operation of the next (N+1)-th page.

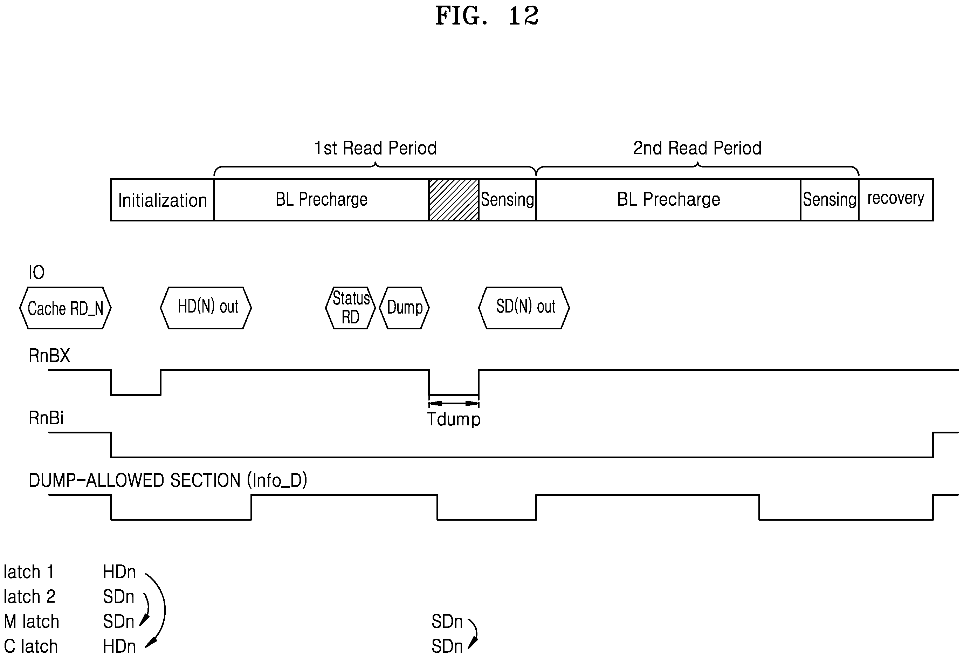

Referring to FIG. 12, the memory device may receive the cache read command Cache RD_N from the memory controller, dump the N-th hard decision data HD(N) stored in the first latch to the cache latch during a logic low section of the external ready/busy signal RnBx, and output the N-th hard decision data HD(N) dumped to the cache latch to the memory controller. In addition, the memory device may perform a read operation with respect to the (N+1)-th page in parallel with the output of the N-th hard decision data HD(N).

The memory controller may output the dump command Dump for outputting soft decision data to the memory device during a dump-allowed section. At this time, when a dump operation of the N-th soft decision data SD(N) may not be completed during the dump-allowed section due to the time Tdump required for the dump operation (i.e. when the time remaining in the dump-allowed section after receipt of the dump command Dump is less than Tdump), the memory device may perform a control operation for delaying a start of a sensing section such that the dump operation of the N-th soft decision data SD(N) is not performed in parallel with a sensing operation with respect to the (N+1)-th page.

In some implementations, the memory device may dump the N-th soft decision data SD(N) to the cache latch in response to the dump command Dump in a state in which the start of the sensing section is delayed, and the sensing operation with respect to the (N+1)-th page may be started after the dump operation is completed. According to the above operations, the N-th hard decision data HD(N) and the N-th soft decision data SD(N), which were read from the N-th page, may all be provided to the memory controller during a read operation of the next (N+1)-th page. According to the implementation shown in FIG. 12, as the start of the sensing section is delayed, even when the section information Info_D has a second logic state, the dump operation with respect to the N-th soft decision data SD(N) may be performed.

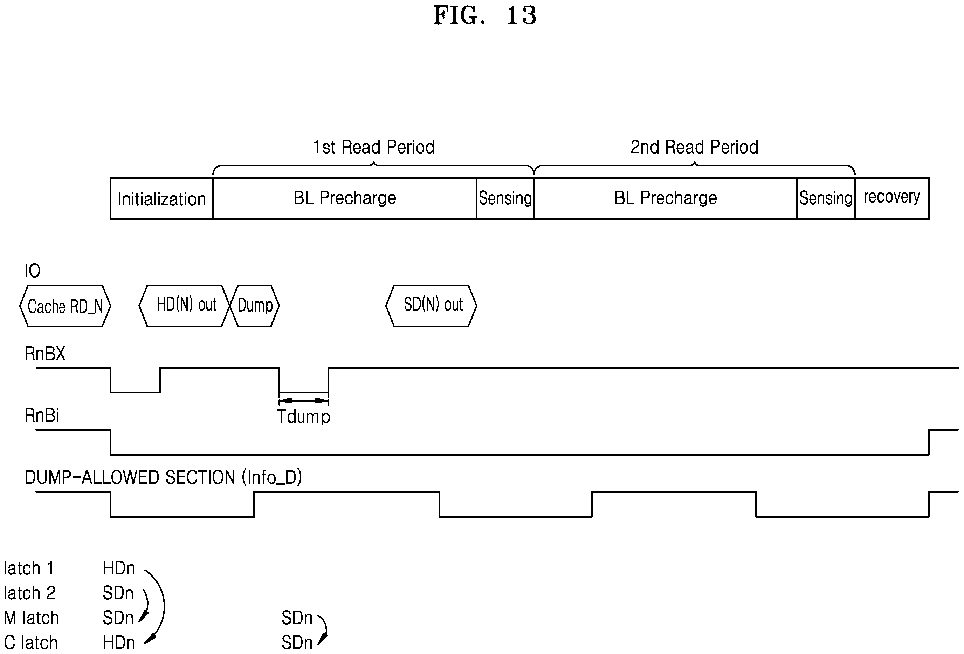

FIG. 13 illustrates a case in which a memory device receives a dump command from a memory controller at any point in time without output outputting the section information Info_D to the memory controller.

Referring to FIG. 13, the memory device may dump the N-th hard decision data HD(N) stored in the first latch to the cache latch in response to the Cache read command Cache RD_N and may output the N-th hard decision data HD(N) dumped to the cache latch to the memory controller. In addition, the memory device may receive the dump command Dump, and when an operation of dumping the N-th soft decision data SD(N) to the cache latch may be completed during a dump-allowed section, the memory device may dump the N-th soft decision data SD(N) to the cache latch in response to the dump command Dump and output the N-th soft decision data SD(N) stored in the cache latch to the memory controller without performing separate queuing for delaying execution of the dump command.

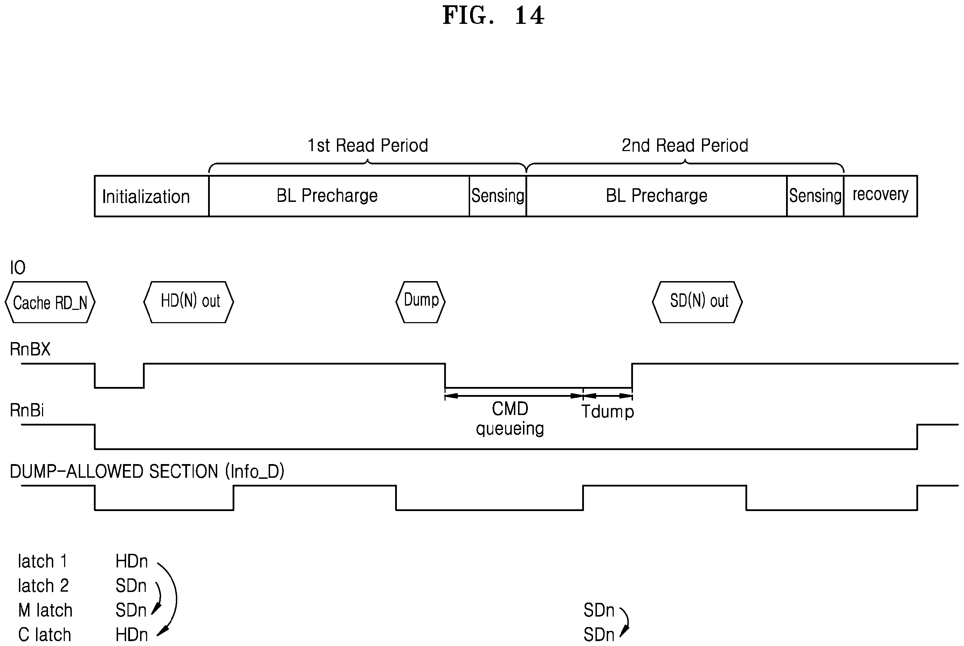

Referring to FIG. 14, the memory device may dump the N-th hard decision data HD(N) stored in the first latch in response to the cache read command Cache RD_N and may output the N-th hard decision data HD(N) dumped to the cache latch to the memory controller. In addition, the memory device may receive the dump command Dump during a first read section, and as the dump command Dump is received after (e.g. outside of) a dump-allowed section that exists in the first read section, the memory device may queue the dump command without executing the dump command Dump.

Thereafter, the memory device may enter a second read section, and a portion of a precharge section of the second read section may correspond to the dump-allowed section. The memory device may dump the N-th soft decision data SD(N) to the cache latch as (e.g. when) entering the dump-allowed section of the second read section, and may output the N-th soft decision data SD(N) stored in the cache latch to the memory controller.

FIG. 14 illustrates a case in which the dump command Dump is provided to the memory device after the dump-allowed section within the first read section, but the present disclosure is not limited thereto. For example, even when the memory device receives the dump command Dump in the dump-allowed section within the first read section, when a dump operation of the N-th soft decision data SD(N) may not be completed during the dump-allowed section within the first read section, the memory device may queue the dump command Dump and execute the dump command Dump in the dump-allowed section of the second read section.

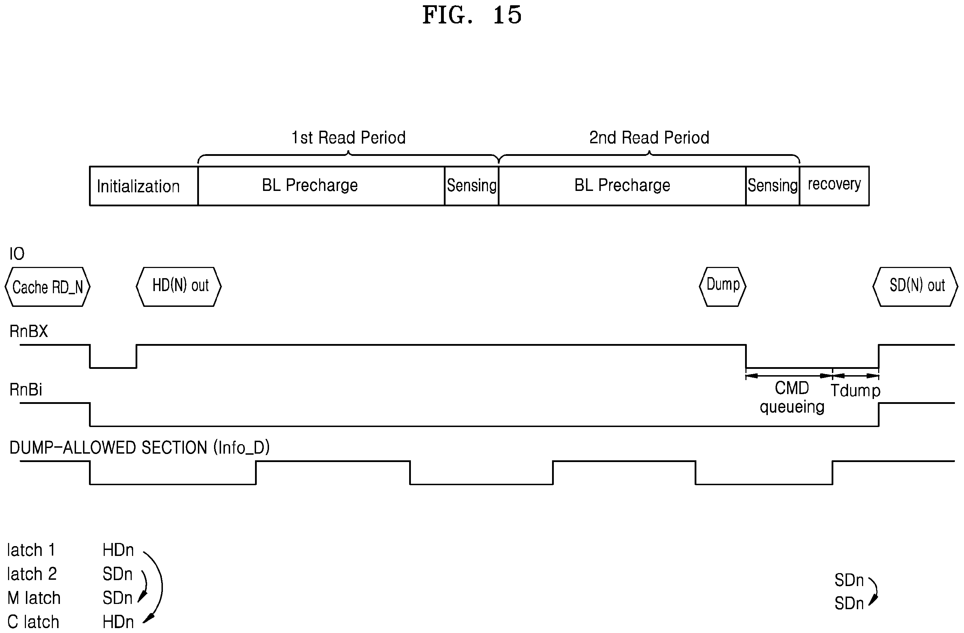

Referring to FIG. 15, the memory device may dump the N-th hard decision data HD(N) stored in the first latch to the cache latch in response to the cache read command Cache RD_N and may output the N-th hard decision data HD(N) dumped to the cache latch to the memory controller. In addition, the memory device may receive the dump command Dump at any point in time, and FIG. 15 illustrates a case in which the dump command Dump is provided to the memory device at a point in time after a dump-allowed section defined in a precharge section of a second read section. The memory device may queue the dump command Dump without executing the dump command Dump as the section information Info_D has a second logic state.

When the second read section with respect to the (N+1)-th page is completed, a recovery operation with respect to various lines and nodes within a page buffer may be performed in a recovery section. In addition, because the recovery section corresponds to a section after the second read section is completed, a dump operation of data may be possible in at least a portion of the recovery section, and according to an implementation, a section including a portion of the recovery section may be defined as a dump-allowed section. After the second section is completed, the memory device may dump the N-th soft decision data SD(N) to the cache latch as the section information Info_D is changed to a first logic state, and may output the N-th soft decision data SD(N) stored in the cache latch to the memory controller.

As shown in FIG. 15, the dump-allowed section according to some implementations may be defined to including various time sections, and for example, may be defined to include at least one other section such as the recovery section, together with a portion of the precharge section. Accordingly, even when a dump command from the memory controller is provided to the memory device at any point in time, the memory device may dump soft decision data to the cache latch in a dump-allowed section at various points in time, and thus both hard decision data and soft decision data may be output together to the memory controller in any one read operation.

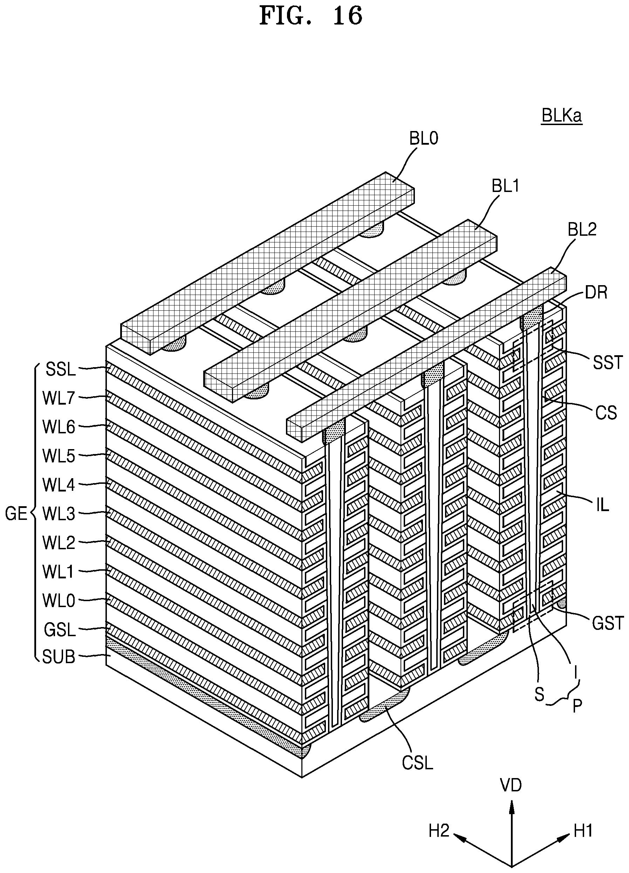

FIG. 16 is a perspective view showing an example of a memory block BLKa.

Referring to FIG. 16, the memory block BLKa may correspond to any one memory block among a plurality of memory blocks provided in the memory cell array 210 of FIG. 1. The memory block BLKa is formed in a vertical direction VD with respect to a substrate SUB having a first conductivity type (e.g., a p type). In some implementations, a common source line CSL doped with impurities of a second conductivity type (e.g., an n type) may be provided on the substrate SUB. In some implementations, the substrate SUB may be implemented with polysilicon, and the common source line CSL having a plate shape may be arranged on the substrate SUB. A plurality of insulating films IL extending in a second direction H2 may be sequentially provided on the substrate SUB in the vertical direction VD, and the plurality of insulating films IL are spaced apart from each other at particular intervals in the vertical direction VD. For example, the plurality of insulating films IL may include an insulating material such as silicon oxide.

A plurality of pillars P sequentially arranged in a first direction H1 and penetrating the plurality of insulating films IL in the vertical direction VD are provided on the substrate SUB. For example, the plurality of pillars P may penetrate the plurality of insulating films IL to be in contact with the substrate SUB. In particular, a surface layer S of each pillar P may include a silicon material having a first type and may function as a channel area. Accordingly, the pillar P may be referred to as a vertical channel structure. An inner layer I of each pillar P may include an insulating material such as silicon oxide or an air gap.

A charge storage layer CS is provided along exposed surfaces of the plurality of insulating films IL, the plurality of pillars P, and the substrate SUB. The charge storage layer CS may include a gate insulating layer, a charge trap layer, and a blocking insulating layer. For example, the charge storage layer CS may have an oxide-nitride-oxide (ONO) structure. In addition, a gate electrode GE, such as a ground selection line GSL, the string selection line SSL, and word lines WL1 to WL8, is provided on an exposed surface of the charge storage layer CS. Drain electrodes DR are respectively provided on the plurality of pillars P. For example, the drains DR may include a silicon material doped with impurities having the second conductivity type. Bit lines BL0 to BL2 extending in the first direction and arranged to be spaced apart from each other with a particular distance in the second direction H2 are respectively provided on the drains DR.

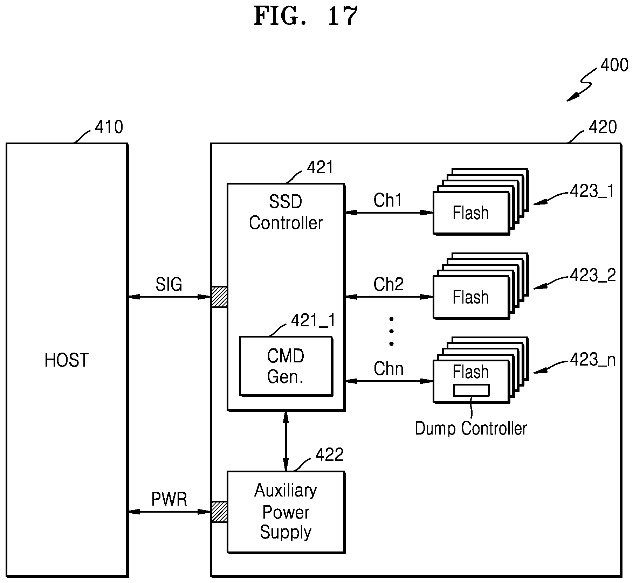

FIG. 17 is a block diagram showing an example of applying a memory device to an SSD system 400.

Referring to FIG. 17, the SSD system 400 may include a host 410 and an SSD 420. The SSD 420 exchanges a signal SIG with the host 410 through a signal interface and receive power PWR through a power connector. The SSD 420 may include an SSD controller 421, an auxiliary power supply 422, and memory devices 423_1 to 423_n. Each of the memory devices 423_1 to 423 _n may be implemented by using the implementations described above with reference to FIGS. 1 to 16.

That is, the SSD controller 421 may correspond to the memory controller described in the above implementations, the memory devices 423_1 to 423_n may correspond to the memory device according to the above implementations, and hard decision data and soft decision data may be transmitted and received between the SSD controller 421 and the memory devices 423_1 to 423_n. The SSD controller 421 may include a command generator 421_1, and the command generator 421_1 may generate a series of commands in relation to read and output of hard decision data and soft decision data of the memory devices 423_1 to 423_n and output the generated commands to the memory devices 423_1 to 423_n. For example, the command generator 421_1 may generate a dump command that requests dump of data while a read operation is performed.

Each of the memory devices 423_1 to 423_n may include a dump controller, and the dump controller may control a dump operation related to read and output of the hard decision data and the soft decision data. For example, according to the above implementations, the dump controller may perform a control operation such that data is dumped to a cache latch in a dump-allowed section while a read operation is performed.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Embodiments are set out in the following clauses:
Clause 1. A memory device comprising:
   a memory cell array comprising a plurality of pages, wherein each page of the plurality of pages comprises a plurality of memory cells;
   a page buffer comprising a plurality of buffer units corresponding to the plurality of memory cells of each page, wherein each buffer unit of the plurality of buffer units comprises a cache latch and first to N-th latches, and N is an integer greater than or equal to 2; and
   a control logic configured to
      control a first read operation with respect to a first page of the plurality of pages, wherein the first read operation stores first hard decision data in the page buffer based on a normal read level and stores first soft decision data in the page buffer based on an offset level,
      output the first hard decision data to a memory controller after a second read operation with respect to a second page of the plurality of pages has started, wherein the second read operation is started in response to a first command that requests read of the second page, and
      output the first soft decision data to the memory controller in response to a second command from the memory controller while the second read operation is being performed.
Clause 2. The memory device of clause 1, wherein the first soft decision data is compressed in the memory device, and the compressed first soft decision data has a smaller size than the first hard decision data.
Clause 3. The memory device of clause 1 or clause 2, wherein the first hard decision data is stored in the first latch, and the first soft decision data is stored in the second latch,
   wherein the control logic is configured to output the first hard decision data stored in the cache latch to the memory controller after dumping the first hard decision data stored in the first latch to the cache latch, and dumping the first hard decision data is performed in response to the first command.
Clause 4. The memory device of clause 3, wherein N is an integer greater than or equal to 3,
   wherein the control logic is configured to dump the first soft decision data stored in the second latch to the third latch in response to the first command, and
   wherein the first soft decision data stored in the third latch is dumped to the cache latch in response to the second command, and the first soft decision data stored in the cache latch is output to the memory controller after the first soft decision data stored in the third latch is dumped to the cache latch.
Clause 5. The memory device of clause 4, wherein the second read operation comprises a precharge section precharging a sensing node of each buffer unit, a development section developing a voltage of the sensing node of each buffer unit, and a sensing section sensing a voltage of the sensing node of each buffer unit, and
   wherein the first soft decision data is dumped to the cache latch in the precharge section.
Clause 6. The memory device of clause 5, wherein the memory device comprises a section information generator configured to generate section information, the section information indicating a dump-allowed section in a read operation with respect to each page, and
   wherein the first soft decision data is dumped to the cache latch while the section information is activated.
Clause 7. The memory device of clause 6, wherein the second command is received before the section information is activated, and
   wherein the memory device is configured to queue the second command and to execute the second command after the section information is activated.
Clause 8. The memory device of clause 6, wherein the memory device is configured to output the section information to the memory controller and to receive the second command from the memory controller while the section information is activated.
Clause 9. The memory device of any of clauses 5-7, wherein the second read operation comprises a first read section and a second read section to determine different distributions among a plurality of threshold voltage distributions, and each read section of the first read section and the second read section comprises the precharge section, the development section, and the sensing section, and
   wherein the second command is provided to the memory device in the first read section, and the first soft decision data is dumped to the cache latch in the precharge section of the second read section.

While the present disclosure has been particularly shown and described with reference to implementations thereof, it will be understood that various changes in form and details may be made therein without departing from the scope of the following claims.

## Claims

1. A memory device comprising:
a memory cell array comprising a plurality of pages, wherein each page of the plurality of pages comprises a plurality of memory cells;
a page buffer comprising a plurality of buffer units corresponding to the plurality of memory cells of each page, wherein each buffer unit of the plurality of buffer units comprises a cache latch and first to N-th latches, and N is an integer greater than or equal to 2; and
a control logic configured to
control a first read operation with respect to a first page of the plurality of pages, wherein the first read operation stores first hard decision data in the page buffer based on a normal read level and stores first soft decision data in the page buffer based on an offset level,
output the first hard decision data to a memory controller after a second read operation with respect to a second page of the plurality of pages has started, wherein the second read operation is started in response to a first command that requests read of the second page, and
output the first soft decision data to the memory controller in response to a second command from the memory controller while the second read operation is being performed.

2. The memory device of claim 1, wherein the memory device is configured to compress the first soft decision data such that the compressed first soft decision data has a smaller size than the first hard decision data.

3. The memory device of claim 1 or claim 2, wherein the first hard decision data is stored in the first latch, and the first soft decision data in the second latch during the first read operation,
wherein the control logic is configured to output the first hard decision data stored in the cache latch to the memory controller after dumping the first hard decision data stored in the first latch to the cache latch, wherein the dumping of the first hard decision data is performed in response to the first command.

4. The memory device of claim 3, wherein N is an integer greater than or equal to 3,
wherein the control logic is configured to dump the first soft decision data stored in the second latch to the third latch in response to the first command, and
wherein the control logic is configured to dump the first soft decision data stored in the third latch to the cache latch in response to the second command, and the first soft decision data stored in the cache latch is output to the memory controller after the first soft decision data stored in the third latch is dumped to the cache latch.

5. The memory device of claim 4, wherein the second read operation comprises a precharge section precharging a sensing node of each buffer unit, a development section developing a voltage of the sensing node of each buffer unit, and a sensing section sensing a voltage of the sensing node of each buffer unit, and
wherein the first soft decision data is dumped to the cache latch in the precharge section.

6. The memory device of claim 5, wherein the memory device comprises a section information generator configured to generate section information, the section information indicating a dump-allowed section in a read operation with respect to each page, and
wherein the first soft decision data is dumped to the cache latch while the section information is activated.

7. The memory device of claim 6, wherein the memory device is configured to, in response to the second command being received before the section information is activated, queue the second command and to execute the second command after the section information is activated.

8. The memory device of claim 6, wherein the memory device is configured to output the section information to the memory controller and to receive the second command from the memory controller while the section information is activated.

9. The memory device of any of claims 5-7, wherein the second read operation comprises a first read section and a second read section to determine different distributions among a plurality of threshold voltage distributions, and each read section of the first read section and the second read section comprises the precharge section, the development section, and the sensing section, and
wherein the memory device is configured to, in response to the second command being provided to the memory device in the first read section, dump the first soft decision data to the cache latch in the precharge section of the second read section.

10. An operating method of a memory device, wherein the memory device comprises a page buffer, and the page buffer comprises a plurality of buffer units corresponding to a plurality of memory cells, the operating method comprising:
receiving a read command with respect to a first page of the memory device;
storing first hard decision data based on a normal read level to a first latch of each buffer unit of the plurality of buffer units, wherein the first hard decision data is read from the first page through a first read operation corresponding to the read command;
storing first soft decision data based on an offset level to a second latch of each buffer unit of the plurality of buffer units, wherein the first soft decision data is read from the first page;
receiving, from a memory controller, a first command, the first command comprising a read request with respect to a second page of the memory device;
outputting, to the memory controller, the first hard decision data after dumping the first hard decision data to a cache latch of each buffer unit of the plurality of buffer units, dumping the first hard decision data being performed in response to receiving the first command;
receiving a second command from the memory controller while a second read operation with respect to the second page is being performed;
in response to receiving the second command, dumping the first soft decision data to the cache latch during a dump-allowed section, the dump-allowed section being defined in the second read operation; and
outputting, to the memory controller, the first soft decision data that is dumped to the cache latch.

11. The operating method of claim 10, wherein the first hard decision data is dumped to the cache latch after the second read operation has started.

12. The operating method of claim 10 or claim 11, comprising dumping the first soft decision data stored in the second latch to a third latch in response to receiving the first command,
wherein the first soft decision data stored in the third latch is dumped to the cache latch in response to receiving the second command.

13. The operating method of any of claims 10-12, wherein the second read operation comprises a precharge section precharging a sensing node of each buffer unit, a development section developing a voltage of the sensing node of each buffer unit, and a sensing section sensing a voltage of the sensing node of each buffer unit, and
wherein the dump-allowed section comprises a portion of the precharge section.

14. The operating method of claim 13, comprising generating section information indicating the dump-allowed section,
wherein an operation of dumping the first soft decision data to the cache latch is performed while the section information is in a first logic state.

15. The operating method of claim 14, comprising based on the second command being received while the section information is in a second logic state, queuing the second command until the section information is changed to the first logic state.
